# EUROPEAN PATENT SPECIFICATION

(11) **EP 4 328 963 B1**
(45) Date of publication and mention of the grant of the patent: **27.08.2025**
(21) Application number: 21940877.0
(22) Date of filing: 21.05.2021
(51) Int. Cl.: H01L 21/48, H01L 23/538, H01L 25/065

(54) **METHOD FOR MANUFACTURING SEMICONDUCTOR DEVICE**
VERFAHREN ZUR HERSTELLUNG EINES HALBLEITERBAUELEMENTS
PROCÉDÉ DE FABRICATION DE DISPOSITIF À SEMI-CONDUCTEURS

(43) Date of publication of application: 28.02.2024
(73) Proprietor: Resonac Corporation, Tokyo 105-7325 (JP)
(72) Inventor: MITSUKURA, Kazuyuki, Tokyo 105-7325 (JP); TOBA, Masaya, Tokyo 105-7325 (JP)
(74) Representative: Hoffmann Eitle
(86) International application number: PCT/JP2021/019445
(87) International publication number: WO 2022/244266

(56) References cited:
- WO-A1-2018/056466
- JP-A- 2000 323 613
- JP-A- 2012 204 701
- JP-B2- S6 049 588
- US-A1- 2019 109 082
- US-B1- 10 115 673
- US-B1- 6 589 813

## Description

### Technical Field

The present invention relates to a method for manufacturing a semiconductor device which includes a method for stacking wiring layers. More specifically, the present invention relates to a method for manufacturing a semiconductor device which is useful for manufacturing a semiconductor device for which miniaturization and high density are highly required in an efficient manner and at the low cost.

### Background Art

Patent Literature 1 discloses a type in which chips having different performance are mixedly mounted in one package to achieve high density and high performance of a semiconductor package. In this type, a cost-effective and high-density interconnect technology between chips is important.

As the interconnect technology, in a semiconductor mounting field, a flip-chip mounting method in which connection between semiconductor chips, and connection between the semiconductor chips and a semiconductor chip mounting support member are achieved through a plurality of conductive bumps has attracted an attention. In the flip-chip mounting method, connection abnormality between the substrate and the semiconductor chips through the conductive bumps may occur due to stress based on a difference in a coefficient of thermal expansion between respective connection members. Therefore, there is known a method of sealing the conductive bumps by filling between the connection members with a resin (underfill material) in order to relax the stress (for example, refer to Patent Literature 2). In addition, it is also examined that a negative-type photosensitive adhesive composition is used for connection between the semiconductor chips and connection between the semiconductor chips and the semiconductor chip mounting support member (for example, refer to Patent Literature 3).

There is suggested a method for manufacturing a solid-state imaging device by stacking semiconductor chips having different function through Cu-Cu junction (for example, refer to Patent Literature 4).

There is also suggested that semiconductor chips are stacked on a build-up substrate, a substrate for a wafer level package, a fan-out type package substrate, an interposer substrate, or the like. In stacking of the semiconductor chips, the following method for stacking semiconductor chips has been examined. A wiring width is expanded through a plurality of redistribution layers, bumps or pads are formed on wirings, and solder is melted by heating and pressurization to stack the semiconductor chips (for example, refer to Non-Patent Literature 1)

US 2019/109082 discloses an organic interposer and a method for manufacturing an organic interposer.

### Citation List

### Patent Literature

Patent Literature 1: Japanese Unexamined Patent Publication No. 2012-529770
Patent Literature 2: Japanese Unexamined Patent Publication No. H10-289969
Patent Literature 3: International Publication No. 2011/049011
Patent Literature 4: Japanese Unexamined Patent Publication No. 2019-179782
Patent Literature 5: US patent application publication US 2019/109082

### Non Patent Literature

Non-Patent Literature 1: Proceedings of 2009 Electronic Components and Technology Conference, 11-13 (2009).

### Summary of Invention

### Technical Problem

In order to match a diameter of a bump or a pad that is formed in a substrate, and a diameter of a bump or a pad that is formed in a semiconductor chip (semiconductor element) to each other, a plurality of redistribution layers are required. According to this, productivity deteriorates. In addition to this, when the redistribution layers are provided, miniaturization or high-density may be insufficient at a part of wiring layers. On the other hand, in a case of connecting a substrate and a semiconductor chip by melting solder, the solder may be deformed and come into contact with an adjacent bump. Thus, a yield ratio of a semiconductor device may deteriorate. In addition, when a distance between solder and solder is shortened, insulation reliability may deteriorate.

The present invention has been made to solve the above-described problem, and an object thereof is to provide a method for manufacturing a semiconductor device at a high yield ratio, which is capable of manufacturing the semiconductor device including a fine and highly dense wiring layer for connection between semiconductor chips, connection between a semiconductor chip and a semiconductor wafer or a semiconductor chip mounting support substrate, or connection between semiconductor wafers.

### Solution to Problem

The present invention relates to a method for manufacturing a semiconductor device. The manufacturing method includes forming a first organic insulating layer including a groove on a substrate; forming a conductive layer formed from a conductive material on the first organic insulating layer so as to fill the groove with the conductive material; removing a portion of the conductive layer on the first organic insulating layer, and acquiring a first wiring structure including a first wiring layer and the first organic insulating layer, the first wiring layer being configured to include the conductive material filled in the groove; providing a second wiring structure including a second organic insulating layer and a second wiring layer, the second wiring layer being configured to include a conductive material that is filled in a groove provided in the second organic insulating layer and is exposed from a surface; and stacking the first wiring structure and the second wiring structure with pressurizing the first and second wiring structures while performing alignment so that the first wiring layer and the second wiring layer correspond to each other. In the stacking, respective wirings of the first wiring layer and respective wirings of the second wiring layer are joined to each other, and the first organic insulating layer and the second organic insulating layer are joined to each other.

According to the manufacturing method, a wiring layer of a semiconductor device is formed by joining the first wiring layer and the second wiring layer which are formed by filling the grooves with the conductive material. In this case, a semiconductor device including a fine and highly dense wiring layer can be manufactured at a high yield ratio.

It is preferable that the method for manufacturing a semiconductor device further includes forming a first barrier metal film on at least one surface between a bottom surface and a side surface of the groove in the first organic insulating layer before forming the conductive layer. In this case, in a semiconductor device that is manufactured, it is possible to prevent deterioration of insulation properties of the wiring layer due to diffusion of the conductive material (for example, copper and the like) from the wiring layer including the first wiring layer into the first organic insulating layer. In this aspect, the thickness of the first barrier metal film may be 0.001 to 0.5 µm. According to this, it is possible to more reliably prevent diffusion of the conductive material into the organic insulating layer, and a cross-sectional area of each wiring of the wiring layer can also be sufficiently secured. The thickness of the first barrier metal film may be less than the half of a lateral width of the groove in the first organic insulating layer or less than the half of a depth of the groove. Even in this case, diffusion of the conductive material can be more reliably prevented as described above.

In the method for manufacturing a semiconductor device, it is preferable that a second barrier metal film is provided on at least a side surface of the groove in the second organic insulating layer in a similar manner as in the first organic insulating layer. In the stacking, it is preferable that alignment of the first wiring layer and the second wiring layer is performed so that a positional deviation between the first barrier metal film on the side surface of the groove in the first organic insulating layer and the second barrier metal film on the side surface of the groove in the second organic insulating layer in a direction intersecting the side surfaces becomes 50% or less with respect to the thickness of the first barrier metal film. In this case, it is possible to more reliably prevent diffusion of the conductive material (for example, copper) that may diffuse from the first wiring layer and the second wiring layer on an inner side to the first organic insulating layer and the second organic insulating layer on an outer side due to the first barrier metal film and the second barrier metal film. Particularly, it is possible to prevent diffusion of the conductive material from a joining site between the first barrier metal film and the second barrier metal film.

In the method for manufacturing a semiconductor device, in the acquiring of the first wiring structure, a portion of the conductive layer on the first organic insulating layer may be removed with polishing so that surface roughness of the first wiring layer of the first wiring structure becomes 0.05 µm or less. In this case, the first wiring layer and the second wiring layer can be more reliably joined each other, and it is possible to cause the wiring layer in the semiconductor device to more appropriately function.

In the method for manufacturing a semiconductor device, surface roughness of the second wiring layer of the second wiring structure may be 0.05 µm or less. In this case, the first wiring layer and the second wiring layer can be more reliably joined each other, and it is possible to cause the wiring layer in the semiconductor device to more appropriately function.

In the method for manufacturing a semiconductor device, melting viscosity of an organic material that constitutes at least one of the first organic insulating layer and the second organic insulating layer at 250°C may be 1 kPa·s to 1 MPa·s. In this case, the first organic insulating layer and the second organic insulating layer can be more reliably joined each other. More specifically, in a case where the melting viscosity of the organic insulating material is less than 1 kPa·s, when removing a portion of the conductive layer on the first organic insulating layer, the first wiring layer may be contaminated due to ductility of the organic insulating layer. However, the melting viscosity of the organic insulating material is 1 kPa·s or more, and thus the contamination can be prevented. In a case where the melting viscosity of the organic insulating material is more than 1 MPa·s, it is necessary to raise a heating temperature when joining organic insulating layers each other, and productivity may decrease. However, the melting viscosity of the organic insulating material is 1 MPa·s or less, and thus the temperature when joining the organic insulating layers each other can be lowered, according to this, the productivity can be improved. In the above described case, the melting viscosity of the material constituting at least one of the first organic insulating layer and the second organic insulating layer at 250°C is preferably 3 kPa·s or more. In this case, flowing of a resin in joining can be further suppressed. The melting viscosity of the organic insulating material at 250°C is preferably 5 kPa·s or more. In this case, stress due to curing shrinkage can be suppressed. On the other hand, the melting viscosity of the organic material that constitutes at least one of the first organic insulating layer and the second organic insulating layer at 250°C is preferably 0.8 MPa·s or less. In this case, it is possible to suppress voids from being formed after joining. The melting viscosity of the organic material at 250°C is preferably 0.5 MPa·s or less. In this case, the first organic insulating layer and the second organic insulating layer can be joined to each other at a low temperature. Accordingly, the melting viscosity of the organic material that constitutes at least one (preferably, both) of the first organic insulating layer and the second organic insulating layer at 250°C is more preferably 5 kPa·s to 0.5 MPa·s.

In the method for manufacturing a semiconductor device, in the acquiring of the first wiring structure, the conductive layer on the first organic insulating layer may be removed with polishing so that a surface of the first wiring layer becomes a state of protruding from a surface of the first organic insulating layer. In this case, it is possible to suppress unevenness from being formed on a joining surface when joining the first wiring structure and the second wiring structure due to a difference in a coefficient of thermal expansion between the organic resin material constituting the organic insulating layers and the metal material constituting the wiring layers, and it is possible to perform stacking of the first wiring structure and the second wiring structure in a more reliable manner.

In the method for manufacturing a semiconductor device, the forming of the first organic insulating layer may include disposing a photosensitive material on the substrate, and exposing and developing the photosensitive material to form the first organic insulating layer. In this case, the first organic insulating layer itself, the groove, and the like can be easily formed, and manufacturing efficiency can be increased.

In the method for manufacturing a semiconductor device, the forming of the first organic insulating layer may include forming the groove on the first organic insulating layer. In this case, when disposing the photosensitive material on the substrate, and exposing and developing the photosensitive material to form the first organic insulating layer including the groove, a finer groove, that is, each wiring of the first wiring layer can be prepared, and miniaturization and high-density of the wiring layer can be promoted.

In the method for manufacturing a semiconductor device, a line width of each wiring of the first wiring layer may be 2 µm or less, and the thickness of each wiring of the first wiring layer may be 1 µm or less. In this case, a finer and highly dense wiring layer can be formed.

In the method for manufacturing a semiconductor device, a first semiconductor element may be disposed on a surface of the substrate which is opposite to the first organic insulating layer, or in the substrate, in the first wiring structure, and a second semiconductor element may be disposed on a surface of the second organic insulating layer which is opposite to the second wiring layer, or in the second organic insulating layer, in the second wiring structure. The first semiconductor element may be electrically connected to the second semiconductor element by a wiring layer in which the first wiring layer and the second wiring layer are joined to each other. In this case, the first semiconductor element and the second semiconductor element can be directly or approximately directly connected to each other by the fine wiring layer. In the semiconductor elements noted here may include at least a semiconductor chip and a semiconductor wafer.

The method of the present invention allows to manufacture a semiconductor device. The semiconductor device includes a first wiring structure including a substrate, a first organic insulating layer that is provided on the substrate and includes a first groove, and a first wiring layer formed from a conductive material filled in the first groove; and a second wiring structure including a second organic insulating layer including a second groove, and a second wiring layer formed from a conductive material filled in the second groove. The first wiring structure is stacked on the second wiring structure so that the first wiring layer and the second wiring layer are joined to each other, and the first organic insulating layer and the second organic insulating layer are joined to each other.

In the semiconductor device, a wiring layer is formed by the first wiring layer and the second wiring layer, and thus, as described above, a semiconductor device including a fine and highly dense wiring layer can be manufactured at a high yield ratio.

The semiconductor device may further include a first semiconductor element disposed on a surface of the substrate which is opposite to the first organic insulating layer, or in the substrate in the first wiring structure; and a second semiconductor element disposed on a surface of the second organic insulating layer which is opposite to the second wiring layer, or in the second organic insulating layer in the second wiring structure. In the semiconductor device, the first semiconductor element may be electrically connected to the second semiconductor element by a wiring layer in which the first wiring layer and the second wiring layer are joined to each other. In this case, the first semiconductor element and the second semiconductor element can be directly or approximately directly connected to each other by a fine wiring.

### Advantageous Effects of Invention

According to the present invention, it is possible to provide a method for manufacturing a semiconductor device which is capable of manufacturing a semiconductor device including a fine and highly dense wiring layer at a high yield ratio.

### Brief Description of Drawings

FIG. 1 is a cross-sectional view schematically illustrating an example of a semiconductor package.
FIG. 2 is a cross-sectional view illustrating a wiring member in the semiconductor package illustrated in FIG. 1.
FIGS. 3A to 3D are cross-sectional views schematically illustrating a process of forming a wiring member according to an embodiment of the present invention.
FIGS. 4A to 4D are cross-sectional views schematically illustrating the process of forming the wiring member according to the embodiment of the present invention.
FIGS. 5A and 5B are cross-sectional views schematically illustrating the process of forming the wiring member according to the embodiment of the present invention.
FIG. 6 is a cross-sectional view schematically illustrating the process of forming the wiring member according to the embodiment of the present invention.

### Description of Embodiments

Hereinafter, embodiments will be described in detail with reference to the accompanying drawings. In the following description, the same reference numeral will be given to the same or equivalent portions, and redundant description will be omitted. It is assumed that positional relationships such as up, down, left, and right are based on positional relationships shown in the drawing unless otherwise stated. Dimensional ratios in the drawings are not limited to illustrated ratios.

In a case where terminologies such as "left", "right", "front surface", "rear surface", "up", "down", "upward", "downward", "first", and "second" are used in description and appended claims, these are illustrative only, and do not imply permanent relative positions. A terminology of "layer" also includes a structure having a shape formed at a part in addition to a structure having a shape formed on the entire surface when observed in a plan view. With regard to a terminology of "process", not only an independent process but also a process that is not clearly distinguished from other processes is included in the terminology as long as an object of the process is accomplished. A numerical range expressed by using "to" represents a range including numeral values described before and after "to" as a minimum value and a maximum value. In numeral value ranges described step by step in this specification, an upper limit value or a lower limit value of a numerical range of any step may be replaced with an upper limit value or a lower limit value of a numeral value range of another step.

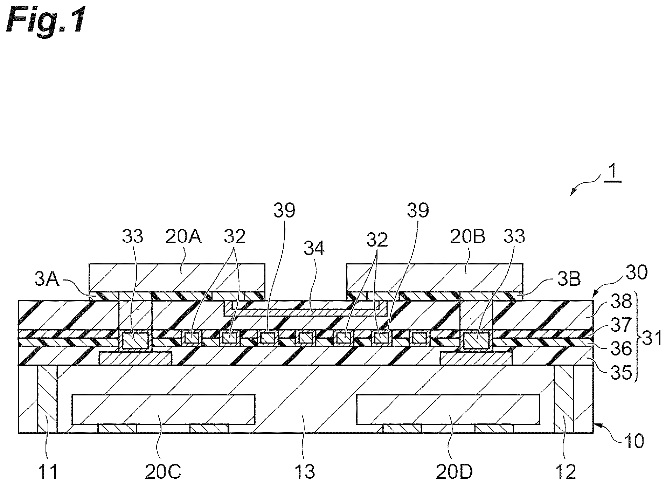

Description will be given of an example of a configuration a semiconductor package 1 (semiconductor device) that is connected by a method for manufacturing a semiconductor device according to this embodiment with reference to FIG. 1. The method for manufacturing a semiconductor device of the present invention is suitable for a type for which miniaturization and multipins (high density) are required. The manufacturing method of the present invention can be used in a package type that requires an interposer for mixedly mounting different types of chips. The manufacturing method of the present invention is not limited to the type, and may be used for other types.

FIG. 1 is a schematic cross-sectional view illustrating an example of a semiconductor package. As illustrated in FIG. 1, the semiconductor package 1 includes a substrate 10, semiconductor chips 20A to 20D (a first semiconductor element and a second semiconductor element), and a wiring member 30. The semiconductor chips 20A and 20B are mounted on the wiring member 30. The semiconductor chips 20C and 20D are disposed inside the substrate 10. The semiconductor chips 20A and 20B may be fixed onto the wiring member 30 by underfills 3A and 3B, or the like, or may be directly fixed onto a fourth insulating layer 38 (to be described later) of the wiring member 30 without using underfills.

As an example, the substrate 10 is a sealed body formed by sealing the semiconductor chips 20C and 20D, and electrodes 11 and 12 with an insulating material 13. The semiconductor chips 20C and 20D inside the substrate 10 may be configured to be connected to an external device through an electrode exposed from the insulating material 13. For example, the semiconductor chips 20C and 20D function as a conductive path for electrically connecting the wiring member 30 and an external device to each other. The insulating material 13 is, for example, a curable resin having an insulating property.

Examples of the semiconductor chips 20A to 20D include a graphic processing unit (GPU), volatile memories such as a dynamic random access memory (DRAM), and a static random access memory (SRAM), nonvolatile memories such as a flash memory, an RF chip, a silicon photonics chip, micro electro mechanical systems (MEMS), and a sensor chip. The semiconductor chips 20A to 20D may include a TSV, and may be, for example, a stack of a plurality of semiconductor elements. In this case, as any one semiconductor chip among the semiconductor chips 20A to 20D, semiconductor elements stacked by using the TSV can be used. The thickness of the semiconductor chips 20A and 20B is, for example, 200 µm or less. From the viewpoint of reducing the thickness of the semiconductor package 1, the thickness of the semiconductor chips 20A and 20B is preferably 100 µm or less. From the viewpoint of handleability, the thickness of the semiconductor chips 20A and 20B is more preferably 30 µm or more.

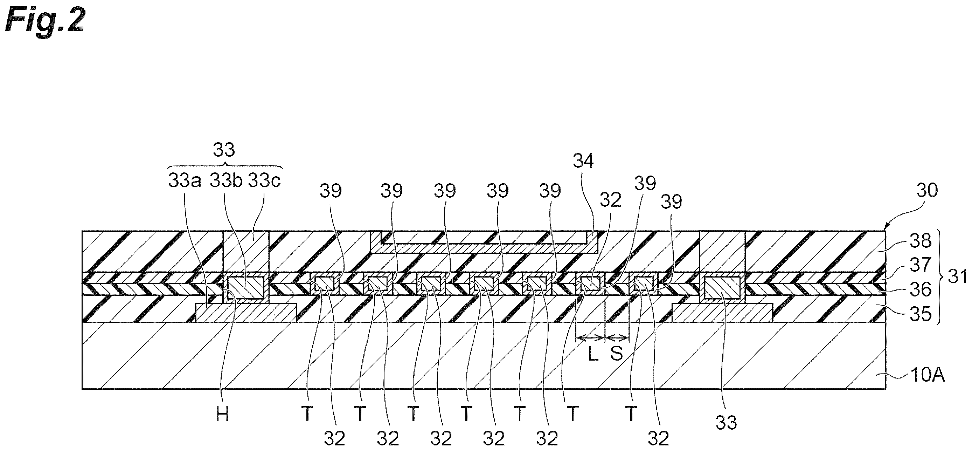

Next, the wiring member 30 will be described in detail with reference to FIG. 2. The wiring member 30 is an organic substrate that supports a semiconductor chip and the like, and may be, for example, a build-up substrate formed by stacking materials (prepregs) obtained by impregnating glass cross or a carbon fiber with a resin, a substrate for a wafer level package, a coreless substrate, a substrate prepared by thermally curing a sealing material, or a substrate in which a chip is sealed or embedded. A shape of the wiring member 30 corresponds to a shape of a substrate 10A to be described later, and may be a wafer shape (approximately circular shape in a plan view) or a panel shape (approximately rectangular shape in a plan view). A coefficient of thermal expansion of the wiring member 30 is preferably, for example, 40 ppm/°C or less from the viewpoint of suppressing warpage. The coefficient of thermal expansion is preferably 20 ppm/°C or less from the viewpoint of insulation reliability of the wiring member 30.

As illustrated in FIG. 2, the wiring member 30 is provided on the substrate 10A. The substrate 10A is a support that supports the wiring member 30. A shape of the substrate 10A in a plan view is, for example, a circular shape or a rectangular shape. In a case of the circular shape, for example, the substrate 10 has a diameter of 200 to 450 mm. In a case of the rectangular shape, for example, one side of the substrate 10 is 300 to 700 mm.

For example, the substrate 10A is a silicon substrate, a glass substrate, or peelable copper foil. The substrate 10A may be, for example, a build-up substrate, a substrate for a wafer level package, a coreless substrate, a substrate prepared by thermally curing a sealing material, or a substrate in which a chip is sealed or embedded. In FIG. 1, a configuration (substrate 10) in which the semiconductor chips 20C and 20D are embedded in the substrate 10A is exemplified, but the substrate 10A may have other configurations. In a case where a silicon substrate, a glass substrate, or the like is used as the substrate 10A, a temporary fixing layer (not illustrated) that temporarily fixes the substrate 10A and the wiring member 30 may be provided. In this case, the substrate 10A can be easily peeled from the wiring member 30 by removing the temporal fixing layer. The peelable copper foil is a stacked body in which a support, a peeling layer, and copper foil are sequentially overlapped. In the peelable copper foil, the support corresponds to the substrate 10A, and the copper foil corresponds to a material of a partial copper wiring included in the through-wiring 33.

The wiring member 30 includes an organic insulating stacked body 31 including a plurality of organic insulating layers, a plurality of wirings 32 arranged inside the organic insulating stacked body 31, a through-wiring 33 that passes through the organic insulating stacked body 31, and a surface wiring 34 that is formed on a surface of the organic insulating stacked body 31 and in the vicinity thereof. A wiring layer of the wiring member 30 is formed from the plurality of wirings 32. The through-wiring 33 and the surface wiring 34 may be included in the wiring layer, or the through-wiring 33 may be electrically connected to any one of the plurality of wirings 32.

The organic insulating stacked body 31 includes a first insulating layer 35 (first organic insulating layer), a second insulating layer 36 (first organic insulating layer), a third insulating layer 37 (second organic insulating layer), and a fourth insulating layer 38 (second organic insulating layer). The first insulating layer 35 to the fourth insulating layer 38 are stacked on the substrate 10A in this order. The organic insulating stacked body 31 includes an opening H in which the through-wiring 33 is provided, and a groove T in which each of the wirings 32 is provided. The first insulating layer 35 and the second insulating layer 36 include an opening Ha in which a part 33 of the through-wiring 33 is provided.

A plurality of the grooves T are provided in the second insulating layer 36 and the third insulating layer 37 to be sandwiched between the first insulating layer 35 and the fourth insulating layer 46. Each of the grooves T has an approximately rectangular shape on a cross-section along a direction orthogonal to an extension direction of the grooves T. That is, each groove T has a bottom surface constituted by a surface of the first insulating layer 35, side surfaces reaching the fourth insulating layer 38 from the bottom surface, and a top surface constituted by a rear surface of the fourth insulating layer 38. The plurality of grooves T have a predetermined line width L (lateral width) and a predetermined space width S. For example, each of the line width L and the space width S is 0.5 to 10 µm, preferably 0.5 to 5 µm, and more preferably 2 to 5 µm. From the viewpoint of realizing high-density transmission of the wiring member 30, the line width L is preferably 1 to 5 µm. The line width L and the space width S may be set to be the same as each other, or may be set to be different from each other. The line width L corresponds to a width of the grooves T (width L in FIG. 2) in a direction orthogonal to the extension direction of the grooves T. The space width S corresponds to a distance between the grooves T adjacent to each other (width S in FIG. 2). For example, the depth of the grooves T corresponds to a total thickness of the second insulating layer 36 and the third insulating layer 37. A cross-sectional shape of the grooves T is not limited to the approximately rectangular shape, and may be other shapes (for example, an approximately semi-circular shape).

Surface roughness of an inner surface of each of the grooves T is preferably 0.01 to 0.1 µm. In a case where the surface roughness is 0.01 µm or more, in the groove T, adhesion and temperature cycle resistance of an object (conductive material) that comes into close contact with the first insulating layer 35, the second insulating layer 36, the third insulating layer 37, and the fourth insulating layer 38 become satisfactory. The temperature cycle resistance stated here represents resistance against a volume variation, a performance deterioration, breakage, and the like in correspondence with a temperature variation. In a case where the surface roughness is 0.1 µm or less, short-circuiting of the wirings 32 formed from a conductive material is suppressed, and high-frequency characteristics of the wirings 32 tend to be improved. The surface roughness of the inner surface of the grooves T is calculated, for example, by observing a cross-section of the grooves T with an electron microscope. The surface roughness is arithmetic average roughness (Ra) defined by JIS B 0601 2001, and the following "surface roughness" is noted as "surface roughness Ra".

A storage modulus of the first insulating layer 35, the second insulating layer 36, the third insulating layer 37, and the fourth insulating layer 38 (hereinafter, may be abbreviated as "respective insulating layers 35 to 38") at room temperature is, for example, 500 MPa to 1000 GPa. The "room temperature" stated here represents approximately 25°C. When the storage modulus is 500 MPa or more, stretching of the respective insulating layers 35 to 38 can be suppressed. For example, in a process of grinding the second insulating layer 36 or the third insulating layer 37, it is possible to prevent the second insulating layer 36 or the third insulating layer that is stretched in accordance with grinding from covering the wirings 32. When the storage modulus is 10 GPa or less, for example, breakage of a grinding blade is prevented, and as a result, a surface of the second insulating layer 36 and the like can be prevented from being excessively rough.

Melting viscosity of an organic material that constitutes the respective insulating layers 35 to 38 at 250°C is preferably 1 kPa·s to 1 MPa·s. In this case, in a manufacturing method to be described later, the second insulating layer 36 and the third insulating layer 37 can be more reliably joined. More specifically, in a case where the melting viscosity of the organic insulating material is less than 1 kPa·s, the wirings 32 (32a) may be contaminated due to ductility of the organic insulating layers when removing a portion of a conductive layer on the second insulating layer 36, but when the melting viscosity of the organic insulating material is 1 kPa·s or more, the contamination can be prevented. When the melting viscosity of the organic insulating material is more than 1 MPa·s, it is necessary to raise a heating temperature when joining the insulating layers 36 and 37, and productivity may decrease, but when the melting viscosity of the organic insulating material is 1 MPa·s or less, the temperature when joining the insulating layers 36 and 37 can be lowered, and the productivity can be improved. In the above-described case, the melting viscosity of the material that constitutes the second insulating layer 36 and the third insulating layer 37 at 250°C is preferably 3 kPa·s or more, and in this case, flowing of a resin in joining can be further suppressed. The melting viscosity of the organic insulating material at 250°C is preferably 5 kPa·s or more, and in this case, a stress due to curing shrinkage can be suppressed. On the other hand, the melting viscosity of the organic material that constitutes the second insulating layer 36 and the third insulating layer 37 at 250°C is preferably 0.8 MPa·s or less, and in this case, it is possible to suppress voids from being formed after joining. The melting viscosity of the organic material at 250°C is preferably 0.5 MPa·s or less, and in this case, it is possible to join the second insulating layer 36 and the third insulating layer 37 at a low temperature. Accordingly, the melting viscosity of the organic material that constitutes the second insulating layer 36 and the third insulating layer 37 at 250°C is more preferably 5 kPa·s to 0.5 MPa·s.

The thickness of each of the insulating layers 35 to 38 is, for example, 0.5 to 10 µm. When the thickness of each of the insulating layers 35 to 38 is 0.5 µm or more, respective insulating layers 35 to 38 contribute to stress relaxation in the organic insulating stacked body 31, and the temperature cycle resistance of the organic insulating stacked body 31 can be improved. When the thickness of each of the insulating layers 35 to 38 is 10 µm or less, warpage of the organic insulating stacked body 31 is suppressed, and wirings and the like can be easily exposed, for example, when grinding the second insulating layer 36 or the third insulating layer 37. From the viewpoint of forming the wirings 32 having a width of 3 µm or less by performing exposure and development, the thickness of the second insulating layer 36 and the third insulating layer 37 is preferably 7 µm or less.

The respective insulating layers 35 to 38 may be formed from a cured material of a photosensitive resin composition. From the viewpoints of flatness and manufacturing cost of the layers, it is preferable to use a material (film-shaped organic insulating material) formed in a film shape in advance when forming the layers. In this case, for example, even when the surface roughness of the substrate 10A is 300 µm or more, a layer in which a value of surface roughness is sufficiently small can be formed. It is preferable that the film-shaped organic insulating material is laminatable at 40°C to 120°C. When the laminatable temperature is set to 40°C or higher, tackiness of the organic insulating material at room temperature is suppressed from being strong and satisfactory handleability can be maintained. When the laminatable temperature is set to 120°C or lower, occurrence of warpage in the organic insulating stacked body 31 can be suppressed.

A coefficient of thermal expansion of each of the respective insulating layers 35 to 38 after curing is, for example, 80 ppm/°C or less from the viewpoint of suppressing warpage of the organic insulating stacked body 31. From the viewpoint of insulation reliability of the wiring member 30, the coefficient of thermal expansion of the respective insulating layers 35 to 38 after being cured is preferably 70 ppm/°C or less. From the viewpoint of stress relaxation and processing accuracy of the organic insulating material, the coefficient of thermal expansion of the respective insulating layers 35 to 38 after being cured is more preferably 20 ppm/°C or more.

Examples of the photosensitive resin composition for forming the respective insulating layers 35 to 38 include a composition containing at least a photoacid generator and a compound having a tertiary amino group or a nitrogen-containing heterocycle. It is preferable that the composition further contains an alkali-soluble resin. The photosensitive resin composition can be prepared in either a negative type or a positive type.

The photoacid generator is not particularly limited as long as the photoacid generator is a compound that generates an acid with photoirradiation. From the viewpoint that an acid is efficiently generated, for example, the photoacid generator is preferably an onium salt compound or a sulfonimide compound. Examples of the onium compound include an iodonium salt and a sulfonium salt. Specific examples of the onium compound include diaryliodonium salts such as diphenyliodonium trifluoromethanesulfonate, diphenyliodonium p-toluenesulfonate, diphenyliodonium hexafluoroantimonate, diphenyliodonium hexafluorophosphate, and diphenyliodonium tetrafluoroborate, triarylsulfonium salts such as triphenylsulfonium trifluoromethanesulfonate, triphenylsulfonium p-toluenesulfonate, and triphenylsulfonium hexafluoroantimonate, 4-tert-butylphenyl-diphenylsulfonium p-toluenesulfonate, and 4,7-di-n-butoxynaphthyltetrahydrothiophenium trifluoromethane sulfonate. Specific examples of the sulfonimide compound include N-(trifluoromethylsulfonyloxy)succinimide, N-(trifluoromethylsulfonyloxy)phthalimide, N-(trifluoromethylsulfonyloxy)diphenylmaleimide, N-(trifluoromethylsulfonyloxy)bicyclo[2.2.1]hept-5-ene-2,3-dicarboximide, N-(trifluoromethylsulfonyloxy)naphthalimide, N-(p-toluenesulfonyloxy)-1,8-naphthalimide, and N-(10-camphorsulfonyloxy)-1,8-naphthalimide.

From the viewpoint of resolution, as the photoacid generator, a compound having a trifluoromethanesulfonate group, a hexafluoroantimonate group, a hexafluorophosphate group, or a tetrafluoroborate group may be used.

The alkali-soluble resin is not particularly limited as long as the alkali-soluble resin has a phenolic hydroxyl group and/or a carboxyl group, and examples thereof include a polybenzoxazole resin, a phenoxy resin, a polysulfone resin, a polyether sulfone resin, a polyphenylene sulfide resin, a polyester resin, a polyether resin, a polycarbonate resin, a polyether ketone resin, a (meth)acrylic copolymer, and a novolac resin, and phenol resin, in addition to a polyester resin, a polyether resin, a polyimide resin, a polyamide resin, a polyamideimide resin, a polyetherimide resin, a polyurethane resin, a polyurethaneimide resin, a polyurethaneamideimide resin, a siloxane polyimide resin, and a polyesterimide resin, copolymers thereof, and precursors thereof (polyamic acid, and the like).

The photosensitive resin composition is preferably soluble in a 2.38% by mass tetramethylammonium aqueous solution (TMAH aqueous solution). From the viewpoints of resolution, storage stability, and insulation reliability of the photosensitive resin composition, the photosensitive resin composition preferably contains a compound having a phenolic hydroxyl group. Examples of the phenolic hydroxy group include phenol/formaldehyde condensed novolac resin, a cresol/formaldehyde condensed novolac resin, a phenol-naphthol/formaldehyde condensed novolac resin, a polyhydroxystyrene and a polymer thereof, a phenol-xylylene glycol condensed resin, a cresol-xylylene glycol condensed resin, and a phenol-dicyclopentadiene condensed resin.

The photosensitive resin composition preferably contains a thermosetting resin. Examples of the thermosetting resin include an acrylate resin, an epoxy resin, a cyanate ester resin, a maleimide resin, an allyl-nadi-imide resin, a phenol resin, a urea resin, a melamine resin, an alkyd resin, an unsaturated polyester resin, a diallyl phthalate resin, a silicone resin, a resorcinol formaldehyde resin, a triallyl cyanurate resin, a polyisocyanate resin, a resin containing tris(2-hydroxyethyl)isocyanurate, a resin containing triaryltrimellitate, and a thermosetting resin synthesized from cyclopentadiene. From the viewpoints of resolution, insulation reliability, and adhesion with a metal in the photosensitive resin composition, the thermosetting resin is more preferably a compound having any one among a methylol group, an alkoxyalkyl group, and glycidyl group.

The respective insulating layers 35 to 38 may contain a filler. The content of the filler in each layer is preferably less than 1% by mass. From the viewpoints of processing easiness and processing accuracy, an average particle size of the filler is, for example, 500 nm or less. It is more preferable that the respective insulating layers 35 to 38 do not contain the filler.

The plurality of wirings 32 are provided in corresponding grooves T as described above, and function as a conductive path at the inside of the wiring member 30. Accordingly, the width of each of the wirings 32 approximately matches the line width L of each of the grooves T, and an interval between the wirings 32 adjacent to each other approximately matches the space width S of the groove T. From the viewpoint that the function as the conductive path is satisfactorily exhibited, each of the wirings 32 preferably contains a metal material having high conductivity. Examples of the metal material having high conductivity include copper, aluminum, and silver. The metal materials tend to diffuse into the organic insulating stacked body 31 due to heating. From the viewpoints of conductivity and cost, the metal material contained in the wirings 32 is preferably copper.

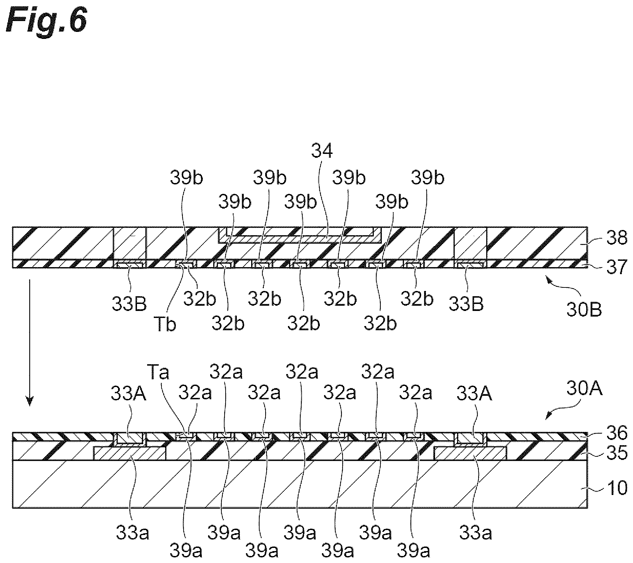

The wirings 32 are preferably covered with a barrier metal film 39 configured to suppress the metal material constituting the wirings 32 from diffusing into the organic insulating stacked body 31. The barrier metal film 39 includes a first barrier metal film 39a provided between the wiring 32 (wiring 32a), and the first insulating layer 35 and the second insulating layer 36, and a second barrier metal film 39b provided between the wiring 32 (wiring 32b), and the third insulating layer 37 and the fourth insulating layer 38 (refer to FIG. 6). The first barrier metal film 39a is provided to partition the wiring 32 (wiring 32a), and the first insulating layer 35 and the second insulating layer 36, and covers a part of side surfaces and a bottom surface of the wiring 32. The second barrier metal film 39b is provided to partition the wiring 32 (wiring 32b), and the third insulating layer 37 and the fourth insulating layer 38, and covers the remaining portion of the side surface of the wiring 32 and a top surface thereof.

The barrier metal film 39 including the first barrier metal film 39a and the second barrier metal film 39b contains, for example, at least one among titanium, nickel, palladium, chromium, tantalum, tungsten, and gold as a metal material that is less likely to diffuse to an organic insulating layer. From the viewpoint of adhesion with an inner surface of the groove T, the barrier metal film 39 is preferably a titanium film or an alloy film containing titanium. From the viewpoint of forming the barrier metal film 39 with sputtering, the barrier metal film 39 is preferably a titanium film, a tantalum film, a tungsten film, a chromium film, or an alloy film containing at least one among titanium, tantalum, tungsten, and chromium.

The thickness of the barrier metal film 39 is less than the half of the width of the groove T or less than the half of the depth of the groove T, and for example, the thickness is 0.001 to 0.5 µm. From the viewpoint of preventing diffusion of the metal material at the inside of the wiring 32, the thickness of the barrier metal film 39 is preferably 0.01 to 0.5 µm. From the viewpoints of increasing flatness of the barrier metal film 39 and the amount of current flowing through the wiring 32, the thickness of the barrier metal film 39 is preferably 0.001 to 0.3 µm. From the above-described viewpoints, the thickness of the barrier metal film 39 is most preferably 0.01 to 0.3 µm. The first barrier metal film 39a and the second barrier metal film 39b are preferably formed from the same material, but may be formed from different materials.

The through-wiring 33 is a wiring that is embedded in the opening H of the organic insulating stacked body 31, and functions as a connection terminal to an external device. The through-wiring 33 includes a plurality of metal layers 33a, 33b, and 33c stacked on each other. The through-wiring 33 is preferably a via shape, and a via diameter is, for example, 1 to 20 µm, preferably 1 to 5 µm, and more preferably 2 to 5 µm.

The surface wiring 34 is a wiring configured to electrically connect, for example, the semiconductor chip 20A and the semiconductor chip 20B mounted on the wiring member 30. Accordingly, both ends of the surface wiring 34 are exposed from the wiring member 30, and the surface wiring 34 other than the both ends is embedded in the wiring member 30 (more specifically, the fourth insulating layer 38). Accordingly, the fourth insulating layer 38 may include two or more organic insulating layers. The surface wiring 34 may not be formed.

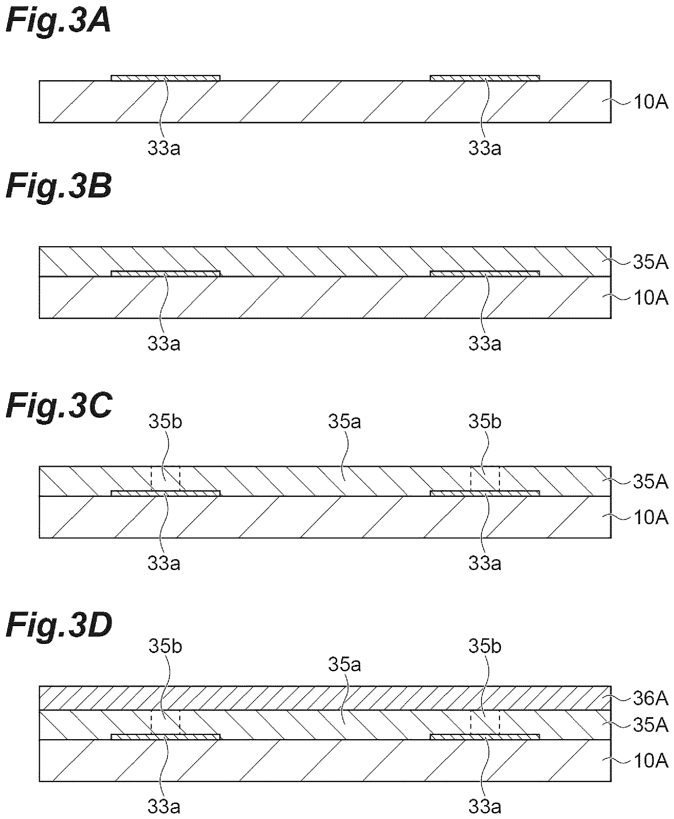

Hereinafter, a method of manufacturing the wiring member 30 will be described with reference to FIGS. 3A-3D to FIG. 6. The manufacturing method according to this embodiment includes (A) a process of forming a first organic insulating layer including a groove on a substrate, (B) a process of forming a first barrier metal film on a bottom surface and a side surface of the groove of the first organic insulating layer, (C) a process of forming a conductive layer formed from a conductive material on the first organic insulating layer to fill the groove with the conductive material, (D) a process of removing a portion of the conductive layer on the first organic insulating layer, and acquiring a first wiring structure including a first wiring layer that includes the conductive material filled in the groove, and a first organic insulating layer, (E) a process of providing a second wiring structure including a second organic insulating layer and a second wiring layer that includes the conductive material that is filled in the groove provided in the second organic insulating layer and is exposed from a surface, and (F) a process of performing alignment so that the first wiring layer and the second wiring layer correspond to each other, and pressurizing the first wiring structure and the second wiring structure to be stacked on each other. In the stacking process, respective wirings of the first wiring layer and respective wirings of the second wiring layer are joined to each other, and the first organic insulating layer and the second organic insulating layer are joined to each other.

First, as illustrated in FIG. 3A, the metal layer 33a is formed on the substrate 10A. The metal layer 33a is formed by patterning a metal film formed on the substrate 10A. In this step, for example, the metal layer 33a is formed by a physical vapor deposition method (PVD method) such as an application method, vapor deposition, and sputtering, a printing method or a spray method that uses metal paste, or various plating methods. In this embodiment, for example, copper foil can be used as the metal film. The metal layer 33a constitutes a part (a lower portion) of the through-wiring 33.

In a case of providing a temporary fixing layer (not illustrated) between the substrate 10A and the metal layer 33a, the temporary fixing layer contains, for example, a resin containing nonpolar components such as polyimide, polybenzoxazole, silicon, and fluorine, a resin containing a component in which volume expansion or foaming occurs due to heating or ultraviolet rays (UV), a resin containing a component in which a crosslinking reaction progresses due to heating or UV, or a resin that generates heat due to photoirradiation. Examples of a method of forming the temporary fixing layer include spin coating, spray coat, and laminate processing. From the viewpoint that handleability and a carrier peeling property are highly compatible with each other, it is preferable that the temporary fixing layer is easily peeled by external stimulus such as light and heat. From the viewpoint that the temporary fixing layer is peelable in order not to remain on the wiring member 30 to be manufactured later, the temporal fixing layer most preferably contains a resin in which volume expansion occurs due to a heating treatment. In a case where the temporal fixing layer is provided between the substrate 10A and the metal layer 33a, the metal layer 33a may be formed from copper foil that is peelable copper foil. In this case, the substrate 10A corresponds to a support of the peelable copper foil, and the temporal fixing layer corresponds to a peeling layer of the peelable copper foil.

Next, as illustrated in FIG. 3B, a first photosensitive resin layer 35A formed from a negative type photosensitive resin composition is formed on the substrate 10A to cover the metal layer 33a.

Next, a photomask is disposed on the first photosensitive resin layer 35A, and the first photosensitive resin layer 35A except for a region to be the opening H is exposed. According to this, as illustrated in FIG. 3C, an exposed portion 35a and a non-exposed portion 35b are formed in the first photosensitive resin layer 35A. As a method of exposing the first photosensitive resin layer 35A, a known projection exposure method, a contact exposure method, a direct drawing exposure method, or the like can be used.

Next, as illustrated in FIG. 3D, a second photosensitive resin layer 36A is formed on a surface of the first photosensitive resin layer 35A after being subjected to the exposure treatment. The thickness of the second photosensitive resin layer 36A is, for example, 7 µm or less.

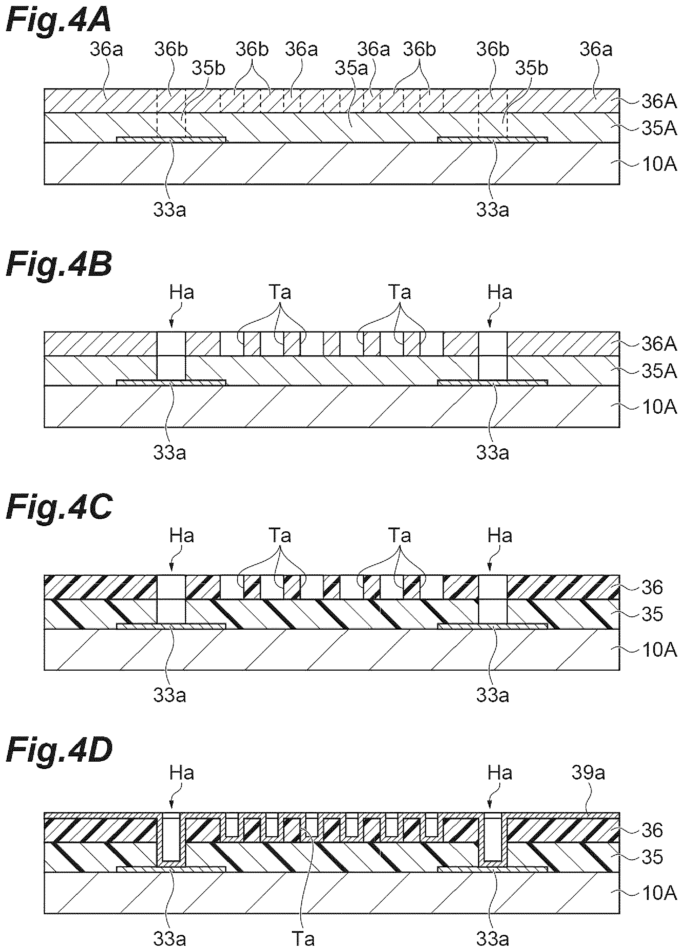

Next, a photomask is disposed on the second photosensitive resin layer 36A, and the second photosensitive resin layer 36A except for regions to be the opening H and the groove T is exposed. According to this, as illustrated in FIG. 4A, an exposed portion 36a and a non-exposed portion 36b are formed in the second photosensitive resin layer 36A. As a method of exposing the second photosensitive resin layer 36A, a known projection exposure method, a contact exposure method, a direct drawing exposure method, or the like can be used.

Next, the first photosensitive resin layer 35A and the second photosensitive resin layer 36A are collectively developed to form an opening Ha that passes through the first photosensitive resin layer 35A and the second photosensitive resin layer 36A, and to form a groove Ta (first groove) in which a surface of the first photosensitive resin layer 35A is set as a bottom surface in the second photosensitive resin layer 36A as illustrated in FIG. 4B. For the development treatment (removal of the non-exposed portions 35b and 36b), for example, an alkali aqueous solution such as sodium carbonate and TMAH, and an organic solvent such as PGMEA, PGME, and cyclopentanone can be used.

Next, the first photosensitive resin layer 35A and the second photosensitive resin layer 36A after development are heated to be cured. For example, a heating temperature is set to 100 to 200°C, and a heating time is set to 30 minutes to 3 hours. According to this, as illustrated in FIG. 4C, the first photosensitive resin layer 35A and the second photosensitive resin layer 36A become the first insulating layer 35 and the second insulating layer 36.

Next, as illustrated in FIG. 4D, the first barrier metal film 39a is formed to cover a surface of the second insulating layer 36, and inner surfaces of the opening Ha and the groove Ta. In this step, the first barrier metal film 39a is formed by using, for example, an application method, a PVD method, a printing method or a spray method that uses metal paste, or various plating methods. In a case of the application method, a complex of palladium or nickel is applied and is heated to form the first barrier metal film 39a. In a case of using the metal paste, paste containing metal particles of nickel, palladium, or the like is applied on the surface of the second insulating layer 36, and the inner surfaces of the opening Ha and the groove Ta, and the paste is sintered to form the first barrier metal film 39a.

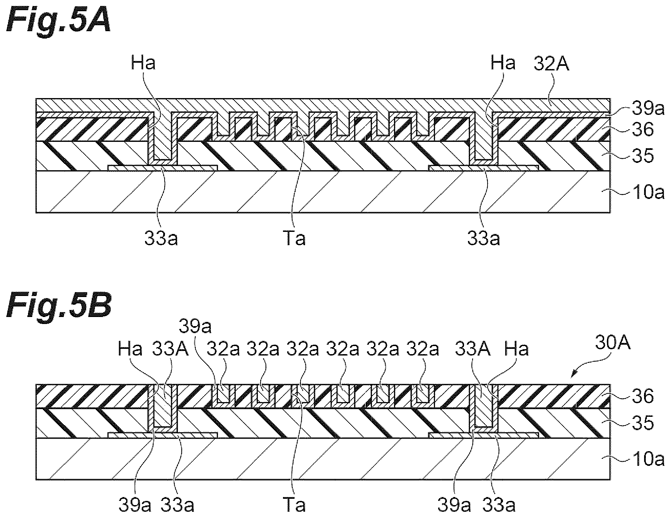

Next, as illustrated in FIG. 5A, a metal layer 32A is formed on the first barrier metal film 39a to fill the opening Ha and the groove Ta. In this step, for example, the metal layer 32A is formed by a method using metal paste, or a plating method using the first barrier metal film 39a as a seed layer. The thickness of the metal layer 32A is preferably 0.5 to 3 times a total thickness of the first insulating layer 35 and the second insulating layer 36. In a case where the thickness of the metal layer 32A is 0.5 or more times the total thickness, surface roughness Ra of the wirings 32 to be formed in a later process tends to be suppressed from being increased. In a case where the thickness of the metal layer 32A is 3 or less times the total thickness, warpage of the metal layer 32A is suppressed, and the metal layer 32A tends to come into close contact with the second insulating layer 36 in a satisfactory manner.

Next, as illustrated in FIG. 5B, the metal layer 32A and the first barrier metal film 39a on the second insulating layer 36 are removed to expose the second insulating layer 36. According to this, the opening Ha is in a state of being filled with a metal, and thus a wiring 33A is formed. The groove Ta is in a state of being filled with a metal that is a conductive material, and thus the wiring 32a is formed. After removing the metal layer 32A and the first barrier metal film 39a, a process of planarizing the surface of the second insulating layer 36 may be carried out. In this case, CMP or a fly cutting method may be employed.

In this step, in a case of using the CMP, as slurry, for example, slurry blended with alumina that is typically used for polishing of a resin, slurry blended with hydrogen peroxide and silica that is used for polishing of the first barrier metal film 39a, and a slurry blended with hydrogen peroxide and ammonium persulfate which are used for polishing of the metal layer 32A can be used. From the viewpoints of reducing the cost and controlling the surface roughness Ra of the second insulating layer 36 and the wirings 32a and 33A to 0.01 to 1 µm (more preferably, 0.05 µm or less), it is preferable to grind the second insulating layer 36, the first barrier metal film 39a, and the metal layer 32A (wiring 32a), and the wiring 33A by using the slurry blended with alumina. In a case where the second insulating layer 36, the first barrier metal film 39a, and the metal layer 32A (wirings 32a and 33A) are simultaneously planarized, dishing occurs in the wirings 32a and 33A due to a difference in a polishing rate, and as a result, flatness of a combined surface of the second insulating layer 36 and the wirings 32a, 33A tends to be greatly impaired. According to this, from the viewpoint of setting the surface roughness Ra of the surface to 0.03 to 0.1 µm, it is more preferably to grind the second insulating layer 36, the first barrier metal film 39a, and the metal layer 32A (wirings 32a and 33A) by a fly cutting method using a surface planar. In the polishing, a surface of the wiring 32a may protrude from the surface of the second insulating layer 36. It is possible to adjust a difference between thermal expansion of the second insulating layer 36 and thermal expansion of the wiring 32a and the like through the polishing.

Through the above-described steps, a first wiring structure 30A having a multi-layer structure as illustrated in FIG. 5B can be formed on the substrate 10A. The first wiring structure 30A illustrated in FIG. 5B can be manufactured by a simpler process in comparison to a wiring layer having a multi-layer structure in the related art.

Next, as illustrated in FIG. 6, a second wiring structure 30B is formed first by the same process as in the first wiring structure 30A formed by the above-described process. For example, the second wiring structure 30B includes the third insulating layer 37, the fourth insulating layer 38, the wiring 32b that is the remaining portion of the wiring 32, a wiring 33B that is the remaining portion of the through-wiring 33, the surface wiring 34, and the second barrier metal film 39b. The wiring 32b and the second barrier metal film 39b (second barrier metal film) are formed inside a groove Tb. The second wiring structure 30B may be prepared by the same manufacturing process as in the first wiring structure 30A, or may be prepared by a different process. As described above, the third insulating layer 37 and the fourth insulating layer 38 may be formed from the same material as in the first insulating layer 35 and the second insulating layer 36, or the wirings 32b and 33B may be formed from the same material as in the wiring 32a and the wiring 33A. A wiring layer (second wiring layer) in the second wiring structure 30B is formed from a plurality of the wirings 32b. The wiring layer may include the wiring 33B and the surface wiring 34. The second wiring structure 30B may include or may not include a substrate corresponding to the substrate 10A, and the substrate may be included during preparation and may be peeled off in the middle. In the second wiring structure 30B, a semiconductor chip and the like may be mounted on a surface of the fourth insulating layer 38 which is opposite to the third insulating layer 37 (or in the fourth insulating layer 38).

Next, when preparation of the second wiring structure 30B is terminated, as illustrated in FIG. 6, alignment is performed so that the respective wirings 32a formed on a surface side of the first wiring structure 30A and the respective wirings 32b formed on a surface side of the second wiring structure 30B correspond to each other, and alignment between the wiring 33A of the first wiring structure 30A and the wiring 33B of the second wiring structure 30B is performed. Then, the second wiring structure 30B is relatively moved toward the first wiring structure 30A, and is stacked thereon while being pressurized. In the stacking, the first wiring structure 30A and the second wiring structure 30B may be pressurized while being heated to be stacked. A heating temperature in this case is, for example, 25 to 300°C. Through the stacking, the respective wirings 32a of the first wiring structure 30A and the respective wirings 32b of the second wiring structure 30B are joined to form the wirings 32, and a plurality of the wirings 33A of the first wiring structure 30A and a plurality of the wirings 33B of the second wiring structure 30B are joined to form a plurality of the through-wirings 33. At this time, a plurality of the first barrier metal films 39a located on an outer side of the respective wirings 32a and a plurality of the second barrier metal films 39b located on an outer side of the respective wirings 32b are aligned and joined to form a plurality of the barrier metal films 39. The entirety of an outer side of the respective wirings 32 is covered with the barrier metal films 39, and the material constituting the wirings 32 is prevented from diffusion into the organic insulating layer. In the stacking process, it is preferable to perform the alignment between the wirings 32a and the wirings 32b so that a positional deviation in a horizontal direction when joining the first barrier metal films 39a and the second barrier metal films 39b becomes 50% or less with respect to the thickness of the barrier metal films 39. When this joining is performed, the second insulating layer 36 of the first wiring structure 30A and the third insulating layer 37 of the second wiring structure 30B are joined to each other. When the second insulating layer 36 and the third insulating layer 37 are joined to each other, the wiring member 30 illustrated in FIG. 2 is formed.

Then, in a case where semiconductor chips and the like are not mounted in the wiring member 30, required semiconductor chips are mounted on a rear surface of the substrate 10, on the fourth insulating layer 38, or the like, thereby completing a semiconductor package.

As described above, according to the method for manufacturing a semiconductor device according to this embodiment, the wiring layer of the semiconductor package 1 is formed by joining the respective wirings 32a and the respective wirings 32b which are formed by filling the grooves Ta and Tb with a conductive material. In this case, the semiconductor package 1 including a fine and highly dense wiring layer can be manufactured at a high yield ratio.

In the method for manufacturing a semiconductor device according to this embodiment, before forming the conductive layer, the first barrier metal film 39a is formed on the bottom surface and the side surface of the groove Ta in the first insulating layer 35 and the second insulating layer 36. In this case, in a semiconductor device that is manufactured, it is possible to prevent deterioration of insulation properties of the wiring 32 due to diffusion of the conductive material (for example, copper and the like) from the wiring 32 including the wiring 32a into the first insulating layer 35 and the second insulating layer 36. The thickness of the first barrier metal film 39a may be 0.001 to 0.5 µm. In this case, it is possible to more reliably prevent diffusion of the conductive material into the organic insulating layer, and a cross-sectional area of each wiring 32 can be sufficiently secured.

In the method for manufacturing a semiconductor device according to this embodiment, the second barrier metal film 39b is provided on the side surface and the bottom surface of the groove Tb (second groove) in the third insulating layer 37 and the fourth insulating layer 38. In the stacking process, it is preferable to perform alignment between the wiring 32a and the wiring 32b so that a positional deviation in a horizontal direction between the first barrier metal film 39a and the second barrier metal film 39b becomes 50% or less with respect to the thickness of the first barrier metal film 39a. In this case, it is possible to more reliably prevent diffusion of the conductive material (for example, copper), which may diffuse from the wiring 32 to the organic insulating stacked body 31 on an outer side due to the first barrier metal film 39a and the second barrier metal film 39b, and particularly, it is possible to prevent diffusion of the conductive material from a joining site between the first barrier metal film 39a and the second barrier metal film 39b.

In the method for manufacturing a semiconductor device according to this embodiment, in a process of acquiring the first wiring structure 30A, a portion of the conductive layer on the second insulating layer 36 may be removed with polishing so that the surface roughness of the wiring 32a of the first wiring structure 30A becomes 0.05 µm or less. The surface roughness of the wiring 32b of the second wiring structure 30B may also be similarly polished. In this case, it is possible to more reliably performing joining between the wiring 32a and the wiring 32b, and the wiring 32 in the semiconductor device can be caused to more appropriately function.

In the method for manufacturing a semiconductor device according to this embodiment, the melting viscosity of the organic material constituting the respective insulating layers 35 to 38 at 250°C may be 1 kPa·s to 1 MPa·s. In this case, joining between the second insulating layer 36 and the third insulating layer 37 can be more reliably performed. More specifically, in a case where the melting viscosity of the organic insulating material is less than 1 kPa·s, when removing a portion of the conductive layer on the second insulating layer 36, the wiring 32a may be contaminated due to ductility of the organic insulating layer. But since the melting viscosity of the organic insulating material is 1 kPa·s or more, the contamination can be prevented. In a case where the melting viscosity of the organic insulating material is more than 1 MPa·s, it is necessary to raise a heating temperature when performing joining between organic insulating layers, and productivity may decrease. But since the melting viscosity of the organic insulating material is 1 MPa·s or less, the temperature when performing joining between the organic insulating layers can be lowered, according to this, the productivity can be improved. In the above-described case, the melting viscosity of the material constituting the respective insulating layers 35 to 38 at 250°C is preferably 3 kPa·s or more, and in this case, flowing of a resin in joining can be further suppressed. The melting viscosity of the organic insulating material at 250°C is preferably 5 kPa·s or more, and in this case, stress due to curing shrinkage can be suppressed. The melting viscosity of the organic material constituting the respective insulating layers 35 to 38 at 250°C is preferably 0.8 MPa·s or less, and in this case, it is possible to suppress voids from being formed after joining. The melting viscosity of the organic material at 250°C is preferably 0.5 MPa·s or less, and in this case, the second insulating layer 36 and the third insulating layer 37 can be joined to each other at a low temperature. Accordingly, the melting viscosity of the organic material constituting the respective insulating layers 35 to 38 at 250°C is more preferably 5 kPa·s to 0.5 MPa·s.

In the method for manufacturing a semiconductor device according to this embodiment, the conductive layer on the second insulating layer 36 may be removed with polishing so that the surface of the wiring 32a becomes a state of protruding from the surface of the second insulating layer 36. The conductive layer on the third insulating layer 37 may be removed with polishing so that the surface of the wiring 32b becomes a state of protruding from the surface of the third insulating layer 37. In this case, it is possible to suppress unevenness from being formed on a joining surface when joining the first wiring structure 30A and the second wiring structure 30B due to a difference in a coefficient of thermal expansion between the organic resin material constituting the organic insulating layers and the metal material constituting the wiring layers, and it is possible to perform stacking of the first wiring structure 30A and the second wiring structure 30B in a more reliable manner.

In the method for manufacturing a semiconductor device according to this embodiment, a photosensitive material is disposed on the substrate 10A, and the photosensitive material is exposed and developed to form the first insulating layer 35 and the second insulating layer 36. In this case, the insulating layer itself, the groove, and the like can be easily formed, and manufacturing efficiency can be increased. A finer groove, that is, wiring 32a can be prepared, and miniaturization and high-density of the wiring layers can be promoted. This is also true of manufacturing the second wiring structure 30B.

In the method for manufacturing a semiconductor device according to this embodiment, a line width of each of the wirings 32a and 32b may be 2 µm or less, and the thickness of each of the wirings 32a and 32b may be 1 µm or less. In this case, a finer and highly dense wiring layer can be formed.

Hereinbefore, the embodiment of the present invention has been described, but the present invention is not limited to the embodiment, and may be appropriately modified in a range not departing from the scope of the present invention as defined by the claims. For example, in the embodiments, an example of connecting semiconductor chips by using the wiring member 30 has been illustrated, but a semiconductor chip and a semiconductor wafer may be connected or semiconductor wafers may be connected to each other by using the wiring member 30. An application can be made to other connections.

### Reference Signs List

1: semiconductor package (semiconductor device), 10, 10A: substrate, 20A to 20D: semiconductor chip (semiconductor element), 30: wiring member, 31: organic insulating stacked body, 32, 32a, 32b: wiring, 35: first insulating layer, 36: second insulating layer, 37: third insulating layer, 38: fourth insulating layer, 39: barrier metal film, 39a: first barrier metal film, 39b: second barrier metal film, T, Ta, Tb: groove.

## Claims

1. A method for manufacturing a semiconductor device (1), comprising:
forming a first organic insulating layer (35) including a groove on a substrate (10, 10A);
forming a conductive layer formed from a conductive material on the first organic insulating layer (35) so as to fill the groove with the conductive material;
removing a portion of the conductive layer on the first organic insulating layer (35), and acquiring a first wiring structure (30A) including a first wiring layer and the first organic insulating layer (35), the first wiring layer being configured to include the conductive material filled in the groove;
providing a second wiring structure (30B) including a second organic insulating layer (36) and a second wiring layer, the second wiring layer being configured to include a conductive material that is filled in a groove provided in the second organic insulating layer (36) and is exposed from a surface;
**characterized by**
stacking the first wiring structure (30A) and the second wiring structure (30B) with pressurizing the first and second wiring structures (30A, 30B) while performing alignment so that the first wiring layer and the second wiring layer correspond to each other,
wherein in the stacking, respective wirings of the first wiring layer and respective wirings of the second wiring layer are joined to each other, and the first organic insulating layer (35) and the second organic insulating layer (36) are joined to each other.

2. The method for manufacturing a semiconductor device (1) according to claim 1, further comprising:
forming a first barrier metal film (39a) on at least one surface between a bottom surface and a side surface of the groove in the first organic insulating layer (35) before forming the conductive layer.

3. The method for manufacturing a semiconductor device (1) according to claim 2,
wherein the thickness of the first barrier metal film (39a) is 0.001 to 0.5 µm.

4. The method for manufacturing a semiconductor device (1) according to claim 2 or 3,
wherein the thickness of the first barrier metal film (39a) is less than the half of a lateral width of the groove in the first organic insulating layer (35) or less than the half of a depth of the groove.

5. The method for manufacturing a semiconductor device (1) according to any one of claims 2 to 4,
wherein a second barrier metal film (39b) is provided on at least a side surface of the groove in the second organic insulating layer (36), and
wherein in the stacking, alignment of the first wiring layer and the second wiring layer is performed so that a positional deviation between the first barrier metal film (39a) on the side surface of the groove in the first organic insulating layer (35) and the second barrier metal film (39b) on the side surface of the groove in the second organic insulating layer (36) in a direction intersecting the side surfaces becomes 50% or less with respect to the thickness of the first barrier metal film (39a).

6. The method for manufacturing a semiconductor device (1) according to any one of claims 1 to 5,
wherein in the acquiring of the first wiring structure (30A), a portion of the conductive layer on the first organic insulating layer (35) is removed with polishing so that surface roughness of the first wiring layer of the first wiring structure (30A) becomes 0.05 µm or less.

7. The method for manufacturing a semiconductor device (1) according to any one of claims 1 to 6,
wherein surface roughness of the second wiring layer of the second wiring structure (30B) is 0.05 µm or less.

8. The method for manufacturing a semiconductor device (1) according to any one of claims 1 to 7,
wherein melting viscosity of an organic material that constitutes at least one of the first organic insulating layer (35) and the second organic insulating layer (36) at 250°C is 1 kPa·s to 1 MPa·s.

9. The method for manufacturing a semiconductor device (1) according to any one of claims 1 to 8,
wherein in the acquiring of the first wiring structure (30A), the conductive layer on the first organic insulating layer (35) is removed with polishing so that a surface of the first wiring layer becomes a state of protruding from a surface of the first organic insulating layer (35).

10. The method for manufacturing a semiconductor device (1) according to any one of claims 1 to 9,
wherein the forming of the first organic insulating layer (35) includes disposing a photosensitive material (35A) on the substrate (10, 10A), and exposing and developing the photosensitive material (35A) to form the first organic insulating layer (35).

11. The method for manufacturing a semiconductor device (1) according to any one of claims 1 to 10,
wherein the forming of the first organic insulating layer (35) includes forming the groove on the first organic insulating layer (35).

12. The method for manufacturing a semiconductor device (1) according to any one of claims 1 to 11,
wherein a line width of each wiring of the first wiring layer is 2 µm or less, and the thickness of each wiring of the first wiring layer is 1 µm or less.

13. The method for manufacturing a semiconductor device (1) according to any one of claims 1 to 12,
wherein in the first wiring structure (30A), a first semiconductor element is disposed on a surface of the substrate (10, 10A) which is opposite to the first organic insulating layer (35), or in the substrate (10, 10A), and
wherein in the second wiring structure (30B), a second semiconductor element is disposed on a surface of the second organic insulating layer (36) which is opposite to the second wiring layer, or in the second organic insulating layer (36), and
wherein the first semiconductor element is electrically connected to the second semiconductor element by a wiring layer in which the first wiring layer and the second wiring layer are joined to each other.

## Patentansprüche

1. Verfahren zur Herstellung eines Halbleiterbauelements (1), umfassend:
das Bilden einer ersten organischen Isolierschicht (35) einschließlich einer Rille auf einem Substrat (10, 10A);
das Bilden einer aus einem leitfähigen Material gebildeten leitfähigen Schicht auf der ersten organischen Isolierschicht (35), um die Rille mit dem leitfähigen Material zu füllen;
das Entfernen eines Abschnitts der leitfähigen Schicht auf der ersten organischen Isolierschicht (35) und das Erwerben einer ersten Verdrahtungsstruktur (30A), die eine erste Verdrahtungsschicht und die erste organische Isolierschicht (35) einschließt, wobei die erste Verdrahtungsschicht so eingerichtet ist, dass sie das in der Rille gefüllte leitfähige Material einschließt;
das Bereitstellen einer zweiten Verdrahtungsstruktur (30B), einschließlich einer zweiten organischen Isolierschicht (36) und einer zweiten Verdrahtungsschicht, wobei die zweite Verdrahtungsschicht so eingerichtet ist, dass sie ein leitfähiges Material einschließt, das in einer in der zweiten organischen Isolierschicht (36) vorgesehenen Rille gefüllt ist und von einer Oberfläche freiliegt;
**gekennzeichnet durch**
Stapeln der ersten Verdrahtungsstruktur (30A) und der zweiten Verdrahtungsstruktur (30B) mit Druckbeaufschlagung der ersten und zweiten Verdrahtungsstrukturen (30A, 30B) beim Ausrichten, sodass die erste Verdrahtungsschicht und die zweite Verdrahtungsschicht einander entsprechen,
wobei bei dem Stapeln die jeweiligen Verdrahtungen der ersten Verdrahtungsschicht und die jeweiligen Verdrahtungen der zweiten Verdrahtungsschicht miteinander verbunden sind und die erste organische Isolierschicht (35) und die zweite organische Isolierschicht (36) miteinander verbunden sind.

2. Verfahren zur Herstellung eines Halbleiterbauelements (1) nach Anspruch 1, weiter umfassend:
das Bilden eines ersten Barrieremetallfilms (39a) auf mindestens einer Oberfläche zwischen einer Bodenfläche und einer Seitenfläche der Rille in der ersten organischen Isolierschicht (35) vor dem Bilden der leitfähigen Schicht.

3. Verfahren zur Herstellung eines Halbleiterbauelements (1) nach Anspruch 2, wobei die Dicke des ersten Barrieremetallfilms (39a) 0,001 bis 0,5 µm beträgt.

4. Verfahren zur Herstellung eines Halbleiterbauelements (1) nach Anspruch 2 oder 3,
wobei die Dicke des ersten Barrieremetallfilms (39a) weniger als die Hälfte einer seitlichen Breite der Rille in der ersten organischen Isolierschicht (35) oder weniger als die Hälfte einer Tiefe der Rille beträgt.

5. Verfahren zur Herstellung eines Halbleiterbauelements (1) nach einem der Ansprüche 2 bis 4,
wobei ein zweiter Barrieremetallfilm (39b) auf mindestens einer Seitenfläche der Rille in der zweiten organischen Isolierschicht (36) vorgesehen ist, und
wobei bei dem Stapeln das Ausrichten der ersten Verdrahtungsschicht und der zweiten Verdrahtungsschicht so durchgeführt wird, dass eine Positionsabweichung zwischen dem ersten Barrieremetallfilm (39a) auf der Seitenfläche der Rille in der ersten organischen Isolierschicht (35) und dem zweiten Barrieremetallfilm (39b) auf der Seitenfläche der Rille in der zweiten organischen Isolierschicht (36) in einer Richtung, die die Seitenflächen schneidet, in Bezug auf die Dicke des ersten Barrieremetallfilms (39a) 50 % oder weniger beträgt.

6. Verfahren zur Herstellung eines Halbleiterbauelements (1) nach einem der Ansprüche 1 bis 5,
wobei beim Erwerben der ersten Verdrahtungsstruktur (30A) ein Abschnitt der leitfähigen Schicht auf der ersten organischen Isolierschicht (35) durch Polieren entfernt wird, sodass die Oberflächenrauheit der ersten Verdrahtungsschicht der ersten Verdrahtungsstruktur (30A) 0,05 µm oder weniger wird.

7. Verfahren zur Herstellung eines Halbleiterbauelements (1) nach einem der Ansprüche 1 bis 6,
wobei die Oberflächenrauheit der zweiten Verdrahtungsschicht der zweiten Verdrahtungsstruktur (30B) 0,05 µm oder weniger beträgt.

8. Verfahren zur Herstellung eines Halbleiterbauelements (1) nach einem der Ansprüche 1 bis 7,
wobei die Schmelzviskosität eines organischen Materials, das mindestens eine der ersten organischen Isolierschicht (35) und der zweiten organischen Isolierschicht (36) bei 250 °C bildet, 1 kPa·s bis 1 MPa·s beträgt.

9. Verfahren zur Herstellung eines Halbleiterbauelements (1) nach einem der Ansprüche 1 bis 8,
wobei beim Erwerben der ersten Verdrahtungsstruktur (30A) die leitfähige Schicht auf der ersten organischen Isolierschicht (35) durch Polieren entfernt wird, sodass eine Oberfläche der ersten Verdrahtungsschicht in einen Zustand übersteht, in dem sie aus einer Oberfläche der ersten organischen Isolierschicht (35) hervorsteht.

10. Verfahren zur Herstellung eines Halbleiterbauelements (1) nach einem der Ansprüche 1 bis 9,
wobei das Bilden der ersten organischen Isolierschicht (35) das Anordnen eines lichtempfindlichen Materials (35A) auf dem Substrat (10, 10A) und das Belichten und das Entwickeln des lichtempfindlichen Materials (35A) zum Bilden der ersten organischen Isolierschicht (35) einschließt.

11. Verfahren zur Herstellung eines Halbleiterbauelements (1) nach einem der Ansprüche 1 bis 10,
wobei das Bilden der ersten organischen Isolierschicht (35) das Bilder der Rille auf der ersten organischen Isolierschicht (35) einschließt.

12. Verfahren zur Herstellung eines Halbleiterbauelements (1) nach einem der Ansprüche 1 bis 11,
wobei eine Linienbreite jeder Verdrahtung der ersten Verdrahtungsschicht 2 µm oder weniger beträgt und die Dicke jeder Verdrahtung der ersten Verdrahtungsschicht 1 µm oder weniger beträgt.

13. Verfahren zur Herstellung eines Halbleiterbauelements (1) nach einem der Ansprüche 1 bis 12,
wobei in der ersten Verdrahtungsstruktur (30A) ein erstes Halbleiterelement auf einer Oberfläche des Substrats (10, 10A) angeordnet ist, die der ersten organischen Isolierschicht (35) gegenüberliegt, oder in dem Substrat (10, 10A), und
wobei in der zweiten Verdrahtungsstruktur (30B) ein zweites Halbleiterelement auf einer Oberfläche der zweiten organischen Isolierschicht (36) angeordnet ist, die der zweiten Verdrahtungsschicht gegenüberliegt, oder in der zweiten organischen Isolierschicht (36), und
wobei das erste Halbleiterelement elektrisch mit dem zweiten Halbleiterelement durch eine Verdrahtungsschicht verbunden ist, in der die erste Verdrahtungsschicht und die zweite Verdrahtungsschicht miteinander verbunden sind.

## Revendications

1. Procédé de fabrication d'un dispositif (1) à semi-conducteurs, comprenant :
la formation d'une première couche isolante organique (35) comportant une rainure sur un substrat (10, 10A) ;
la formation d'une couche conductrice formée à partir d'un matériau conducteur sur la première couche isolante organique (35) de manière à remplir la rainure avec le matériau conducteur ;
le retrait d'une partie de la couche conductrice sur la première couche isolante organique (35), et l'obtention d'une première structure (30A) de câblages comportant une première couche de câblages et la première couche isolante organique (35), la première couche de câblages étant configurée pour incorporer le matériau conducteur rempli dans la rainure ;
la fourniture d'une seconde structure (30B) de câblages comportant une seconde couche isolante organique (36) et une seconde couche de câblages, la seconde couche de câblages étant configurée pour incorporer un matériau conducteur qui est rempli dans une rainure disposée dans la seconde couche isolante organique (36) et est exposé à partir d'une surface ;
**caractérisé par**
l'empilement de la première structure (30A) de câblages et de la seconde structure (30B) de câblages avec pressurisation des première et seconde structures (30A, 30B) de câblages tout en réalisant un alignement de sorte que la première couche de câblages et la seconde couche de câblages correspondent l'une à l'autre,
dans lequel dans l'empilement, des câblages respectifs de la première couche de câblages et des câblages respectifs de la seconde couche de câblages sont assemblés ensemble, et la première couche isolante organique (35) et la seconde couche isolante organique (36) sont assemblées ensemble.

2. Procédé de fabrication d'un dispositif (1) à semi-conducteurs selon la revendication 1, comprenant en outre :
la formation d'un premier film métallique barrière (39a) sur au moins une surface entre une surface inférieure et une surface latérale de la rainure dans la première couche isolante organique (35) avant formation de la couche conductrice.

3. Procédé de fabrication d'un dispositif (1) à semi-conducteurs selon la revendication 2,
dans lequel l'épaisseur du premier film métallique barrière (39a) est de 0,001 à 0,5 µm.

4. Procédé de fabrication d'un dispositif (1) à semi-conducteurs selon la revendication 2 ou la revendication 3,
dans lequel l'épaisseur du premier film métallique barrière (39a) est inférieure à la moitié d'une largeur transversale de la rainure dans la première couche isolante organique (35) ou inférieure à la moitié d'une profondeur de la rainure.

5. Procédé de fabrication d'un dispositif (1) à semi-conducteurs selon l'une quelconque des revendications 2 à 4,
dans lequel un second film métallique barrière (39b) est disposé sur au moins une surface latérale de la rainure dans la seconde couche isolante organique (36), et
dans lequel, dans l'empilement, un alignement de la première couche de câblages et de la seconde couche de câblages est réalisé de sorte qu'un écart de position entre le premier film métallique barrière (39a) sur la surface latérale de la rainure dans la première couche isolante organique (35) et le second film métallique barrière (39b) sur la surface latérale de la rainure dans la seconde couche isolante organique (36) dans une direction qui croise les surfaces latérales devient égal à 50 % ou moins par rapport à l'épaisseur du premier film métallique barrière (39a).

6. Procédé de fabrication d'un dispositif (1) à semi-conducteurs selon l'une quelconque des revendications 1 à 5,
dans lequel, lors de l'acquisition de la première structure (30A) de câblages, une partie de la couche conductrice sur la première couche isolante organique (35) est retirée par polissage de sorte qu'une rugosité de surface de la première couche de câblages de la première structure (30A) de câblages devient égale à 0,05 µm ou moins.

7. Procédé de fabrication d'un dispositif (1) à semi-conducteurs selon l'une quelconque des revendications 1 à 6,
dans lequel la rugosité de surface de la seconde couche de câblages de la seconde structure (30B) de câblages est de 0,05 µm ou moins.

8. Procédé de fabrication d'un dispositif (1) à semi-conducteurs selon l'une quelconque des revendications 1 à 7,
dans lequel la viscosité de fusion d'un matériau organique qui constitue au moins l'une parmi la première couche isolante organique (35) et la seconde couche isolante organique (36) à 250 °C est de 1 kPa·s à 1 MPa·s.

9. Procédé de fabrication d'un dispositif (1) à semi-conducteurs selon l'une quelconque des revendications 1 à 8,
dans lequel, lors de l'acquisition de la première structure (30A) de câblages, la couche conductrice sur la première couche isolante organique (35) est retirée par polissage de sorte qu'une surface de la première couche de câblages devient un état de saillie à partir d'une surface de la première couche isolante organique (35).

10. Procédé de fabrication d'un dispositif (1) à semi-conducteurs selon l'une quelconque des revendications 1 à 9,
dans lequel la formation de la première couche isolante organique (35) comporte la mise en place d'un matériau photosensible (35A) sur le substrat (10, 10A), et l'exposition et le développement du matériau photosensible (35A) pour former la première couche isolante organique (35).

11. Procédé de fabrication d'un dispositif (1) à semi-conducteurs selon l'une quelconque des revendications 1 à 10,
dans lequel la formation de la première couche isolante organique (35) comporte la formation de la rainure sur la première couche isolante organique (35).

12. Procédé de fabrication d'un dispositif (1) à semi-conducteurs selon l'une quelconque des revendications 1 à 11,
dans lequel une largeur de ligne de chaque câblage de la première couche de câblages est de 2 µm ou moins, et l'épaisseur de chaque câblage de la première couche de câblages est de 1 µm ou moins.

13. Procédé de fabrication d'un dispositif (1) à semi-conducteurs selon l'une quelconque des revendications 1 à 12,
dans lequel, dans la première structure (30A) de câblages, un premier élément semi-conducteur est placé sur une surface du substrat (10, 10A) qui est opposée à la première couche isolante organique (35), ou dans le substrat (10, 10A), et
dans lequel, dans la seconde structure (30B) de câblages, un second élément semi-conducteur est placé sur une surface de la seconde couche isolante organique (36) qui est opposée à la seconde couche de câblages, ou dans la seconde couche isolante organique (36), et
dans lequel le premier élément semi-conducteur est connecté électriquement au second élément semi-conducteur par une couche de câblages dans laquelle la première couche de câblages et la seconde couche de câblages sont assemblées ensemble.
